# EUROPEAN PATENT APPLICATION

(11) **EP 4 421 998 A1**
(43) Date of publication of application: **28.08.2024**
(21) Application number: 22900496.5
(22) Date of filing: 30.11.2022
(51) Int. Cl.: H01R 13/405, H01R 13/502, H05K 7/20, B60L 53/16, B60L 53/302

(54) **CHARGING TERMINAL, CHARGING GUN, CHARGING PILE AND VEHICLE**

(30) Priority: 01.12.2021 CN 202111456224
(71) Applicant: Huawei Digital Power Technologies Co., Ltd., Shenzhen, Guangdong 518043 (CN)
(72) Inventor: LI, Wenkang, Shenzhen, Guangdong 518043 (CN); LIAN, Zhisheng, Shenzhen, Guangdong 518043 (CN)
(74) Representative: Gill Jennings & Every LLP
(86) International application number: PCT/CN2022/135230
(87) International publication number: WO 2023/098692

(57) **Abstract**

This application provides a charging terminal, a charging connector, a charging pile, and a vehicle. The charging terminal comprises a terminal body and a heat dissipation structure. The terminal body includes a housing and a heat conduction structure. The housing includes a first end and a second end. The housing has a sealing cavity. The sealing cavity extends from the first end to the second end. The heat conduction structure is connected to an inner wall of the sealing cavity, and extends from the first end to the second end. The heat dissipation structure is connected to the second end of the housing. According to the technical solutions of this application, good heat dissipation can be implemented for the charging terminal while ensuring that the charging terminal has good working reliability, so that the charging connector in which the charging terminal is used has a good heat dissipation benefit.

## Description

This application claims priority to Chinese Patent Application No. 202111456224.X, filed with the China National Intellectual Property Administration on December 1, 2021 and entitled "CHARGING TERMINAL, CHARGING CONNECTOR, CHARGING PILE, AND VEHICLE", which is incorporated herein by reference in its entirety.

### TECHNICAL FIELD

This application relates to the field of heat dissipation technologies, and in particular, to a charging terminal, a charging connector, a charging pile, and a vehicle.

### BACKGROUND

With rapid development of the new energy vehicle industry, an endurance mileage of an electric vehicle is continuously increased, and a capacity of a battery is also increasingly large. Consequently, heat consumption of a charging connector that charges the vehicle is sharply increased, and heat dissipation of a charging terminal of the charging connector directly affects working reliability and charging performance of the charging connector. How to implement good heat dissipation of the charging terminal while ensuring that the charging terminal has good working performance is a subject of continuous exploration in the industry.

### SUMMARY

Embodiments of this application provide a charging terminal, a charging connector, a charging pile, and a vehicle, to implement good heat dissipation for the charging terminal while ensuring that the charging terminal has good working reliability, so that the charging connector in which the charging terminal is used has a good heat dissipation benefit.

According to a first aspect, this application provides a charging terminal, where the charging terminal includes:
a terminal body, where the terminal body includes a housing and a heat conduction structure, the housing comprises a first end and a second end, the housing has a sealing cavity, the sealing cavity extends from the first end to the second end, and the heat conduction structure is connected to an inner wall of the sealing cavity and extends from the first end to the second end; and
a heat dissipation structure, where the heat dissipation structure is connected to the second end of the housing.

The first end is an end that is connected to a charging socket, and may be understood as a head end of the housing. The second end is the other end away from the charging socket, and may be understood as a tail end of the housing.

It may be understood that, when the charging terminal works, a current passes through the charging terminal. Because of existence of contact resistance and resistance of the terminal itself, heat consumption of one end, namely, the first end, that is of the terminal and that is in contact with the charging socket is large, and heat of the end needs to be conducted and dissipated in time, to avoid a temperature of the charging terminal exceeding a threshold. A length of the terminal body is large, to be specific, a distance between the first end of the charging terminal and the second end of the charging terminal is long. Therefore, when the charging terminal works, heat generated during charging is conducted from the first end to the second end with large heat resistance, resulting in poor heat dissipation performance of the charging terminal.

In this way, a sealing cavity extending from the first end to the second end is disposed inside the terminal body, and the heat conduction structure is accommodated in the sealing cavity and extends from the first end to the second end. On the one hand, because of good sealing performance of the sealing cavity, heat conduction performance of the heat conduction structure accommodated in the sealing cavity is not affected by an external environment factor. On the other hand, an extension path of the heat conduction structure and an extension path of the housing can overlap and be distributed at various positions on an extension path of the housing.

In this disposing manner, when the charging terminal works, the heat conduction structure can quickly transfer heat generated by the first end of the housing, namely, the end that is in contact with the charging socket, to the second end of the housing in a timely manner, and dissipate the heat by using the heat dissipation structure disposed at the second end. In other words, the heat conduction structure extends from the first end to the second end, so that a temperature of the housing can be more consistent. This not only can fully ensure temperature uniformity of the housing, but also significantly improve heat transfer efficiency between the first end and the second end, thereby improving overall heat dissipation performance of the charging terminal, and improving overall working reliability of the charging terminal.

In a possible implementation, the heat conduction structure includes a capillary structure and a first cooling medium. The capillary structure covers the inner wall of the sealing cavity. The first cooling medium is filled in the capillary structure. An area enclosed by the capillary structure forms a steam channel for the first cooling medium. The first cooling medium is configured to transfer heat at the first end to the second end through gas-liquid conversion.

The capillary structure may be implemented by using a structure such as sintering, a liquid absorption core, a braided mesh (mesh), or a fine fiber (fine fiber). The first cooling medium may be any conductive or non-conductive liquid having a two-phase conversion function (that is, capable of vaporizing when heated and liquefying when cooled). For example, the first cooling medium may include a combination of one or more of water, an inert fluoride liquid, a refrigerant R134a(1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

It may be understood that, because the first end of the housing is in direct contact with the charging socket, the first end of the housing has a high temperature during working, and is an evaporation end of the charging terminal. The second end of the housing has a low temperature because the second end is disposed away from the charging socket and close to the heat dissipation structure, and is a condensation end of the charging terminal.

The first cooling medium is filled in the capillary structure, and the capillary structure covers the inner wall of the sealing cavity. Therefore, the first cooling medium can have a large contact area with the housing. When the charging terminal works and heats up, the first cooling medium may carry heat of the housing in time, and vaporize after being heated at the evaporation end (namely, the first end) due to the two-phase conversion performance of the first cooling medium. Vapor formed after the vaporization is cooled and condensed at the condensation end (namely, the second end), becomes a liquid through cooling, and quickly flows back under a capillary force of the capillary structure. Therefore, heat transfer between the first end and the second end can be implemented in a cycle through continuous gas-liquid conversion of "evaporation-condensation-evaporation" of the first cooling medium. Heat transfer efficiency is high and contact heat conduction performance is good.

The area enclosed by the capillary structure forms the steam channel for the first cooling medium. That is, all areas outside the coverage area of the capillary structure in the sealing cavity may be understood as the steam channel for the first cooling medium, and the steam channel can extend from the first end to the second end.

It may be understood that, the steam channel is reserved in the sealing cavity, to provide a proper space for steam to flow. There is a distance difference between the first end and the second end, and the distance difference is conducive to implementing two-phase conversion of the first cooling medium, so that the first cooling medium evaporates and flows to the second end when being heated at the first end, and condenses and flows back to the first end under a capillary force of a capillary structure after being cooled at the second end. The gas-liquid conversion of the cooling medium is implemented in a cycle.

In a possible implementation, the heat conduction structure is connected to the housing to form an integrated structure.

That is, the terminal body is of the integrated structure. In this disposing manner, on the one hand, because there is no other mechanical part between the heat conduction structure and the housing, heat resistance of contact between the heat conduction structure and the housing can be reduced. This helps improve overall heat conduction performance of the charging terminal. On the other hand, the integrated structure can make processing and manufacturing of the terminal body simple, which helps improve overall structural strength of the terminal body and improve production efficiency of preparing the terminal body.

For example, the heat conduction structure and the housing may be of the integrated structure formed by using assembly such as welding or bonding, or the heat conduction structure and the housing may be of an integrated structure formed by using an integrated molding process. In addition, an insulation cap interface may be disposed at the first end of the housing to accommodate an insulation cap.

In a possible implementation, the housing includes an outer housing and an inner housing, the outer housing has a mounting groove, the mounting groove is configured to accommodate the inner housing, and the inner housing has the sealing cavity.

Two ends of the outer housing are the first end and the second end of the housing described above. Specifically, the insulation cap interface may be disposed at one end (namely, the first end) that is of the outer housing and that is in contact with the charging socket, to accommodate the insulation cap. The other end (namely, the second end) that is of the outer housing and that is away from the charging socket is provided with the mounting groove extending from one end to the other end, so that the inner housing is accommodated in the mounting groove.

In this disposing manner, the inner housing and the heat conduction structure may jointly form a heat conduction member that can independently perform heat conduction, and the mounting groove is disposed in the outer housing. On one hand, the heat conduction member formed by the inner housing and the heat conduction structure can be conveniently and quickly inserted into the mounting groove, so that the heat conduction member can be closely combined with the outer housing, to achieve good heat conduction performance of the charging terminal. On the other hand, the heat conduction member may be replaced in time after the working life of the heat conduction member expires. This helps ensure working reliability of the charging terminal.

For example, a manner of combining the inner housing and the outer housing may be but is not limited to an interference fitting manner, a crimping manner, a welding manner, or the like.

It should be noted that, in this implementation, an example in which a groove structure that can be accommodated by the inner housing is formed inside the outer housing is used for description. However, in another implementation, a hole structure (for example, a blind hole) that can be accommodated by the inner housing may also be formed inside the outer housing. This implementation is not strictly limited thereto.

In a possible implementation, the terminal body is a heat pipe.

That is, the housing and the heat conduction structure may jointly form the heat pipe, and the heat pipe may directly form the terminal body, so that the terminal body not only has good heat conduction performance, but also can achieve good electrical connection performance.

For example, in consideration of sealing of the heat pipe, the first end of the housing may not be provided with an interface, but the insulation cap is disposed on an end face of the first end of the housing. A connection manner in which the insulation cap is disposed at the first end of the housing may be but is not limited to bonding, crimping, welding, or the like. However, due to a structure rule of the heat pipe, to facilitate disposing of the heat dissipation structure, a ribbed plate may be additionally disposed on an outer periphery of the housing, to connect the heat dissipation structure. In addition, an outer surface of the terminal body may be plated with silver, to reduce contact resistance between the terminal body and the charging socket, thereby helping ensure working performance of the charging terminal.

It should be noted that, in this implementation, the wall thickness of the housing may be properly thickened while ensuring working performance. This is conducive to improving overall structural strength of the terminal body.

In a possible implementation, the heat dissipation structure includes a connecting piece, a liquid pipe, and a second cooling medium. One end of the connecting piece is connected to the second end of the housing. The other end of the connecting piece is configured to connect to a cable. The liquid pipe is wound around a periphery of the connecting piece. The second cooling medium flows in the liquid pipe.

Specifically, the connecting piece may be made of a highly heat conductive and conductive material, such as metal or graphite. The connecting piece includes a first connection end and a second connection end. The first connection end is an end that is of the connecting piece and that is connected to the terminal body, and the second connection end is an end that is of the connecting piece and that is connected to the cable. In other words, the first connection end is connected to the second end of the terminal body, and the second connection end is connected to the cable.

A first accommodating hole is concavely disposed on an end face of the first connection end, and a tail end of the terminal body is accommodated in the first accommodating hole. A second accommodating hole is concavely disposed on an end face of the second connection end, and at least a part of the cable is accommodated in the second accommodating hole. Both the first accommodating hole and the second accommodating hole are of a blind hole structure.

In this implementation, the connecting piece and the terminal body may be connected in a detachable connection manner. The detachable connection manner can facilitate assembly of the terminal body and the connecting piece when the terminal body and the connecting piece need to be connected, and can be separated from each other when the terminal body and/or the connecting piece need to be repaired or replaced. In this way, disassembly and assembly are quick and convenient, and maintenance is convenient. This helps improve maintenance efficiency.

For example, a detachable connection manner between the connecting piece and the terminal body may be, but is not limited to, threaded connection, fastener connection, crimping, or a detachable clamp added at a joint between the connecting piece and the terminal body.

The liquid pipe is disposed around the periphery of the connecting piece, and the second cooling medium flows in the liquid pipe to take away heat. For example, the liquid pipe may be made of an insulation material. The second cooling medium may include a combination of one or more of water, an inert fluoride liquid, a refrigerant R134a (1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

It may be understood that, when the charging terminal works, heat generated by the first end of the terminal body is transferred to the second end of the terminal body by using the heat conduction structure, and then is transferred to the connecting piece in contact with the second end of the terminal body. The liquid pipe is spirally wound around the connecting piece, and the second cooling medium enters the liquid pipe through an inlet of the liquid pipe, carries the heat transferred by the connecting piece in a flow process in the liquid pipe, flows out through an outlet of the liquid pipe, and completes heat exchange with the connecting piece. This implements heat dissipation for the terminal body. In this disposing manner, the heat dissipation structure is simple in overall architecture and low in requirement for insulation of the cooling medium, and helps meet application requirements in a plurality of scenarios.

It should be noted that the liquid pipe may independently dissipate heat for any charging terminal. For example, the liquid pipe may independently dissipate heat for a positive charging terminal or a negative charging terminal. In other words, the liquid pipe is independently wound around the positive charging terminal or the negative charging terminal. Alternatively, the liquid pipe may dissipate heat for a plurality of charging terminals together. For example, the liquid pipe may dissipate heat for both a positive charging terminal and a negative charging terminal. In other words, the liquid pipe is wound around the positive charging terminal and the negative charging terminal. A heat dissipation form of the liquid pipe is not strictly limited in this implementation.

In a possible implementation, the heat dissipation structure further includes a heat shrink tube, and the heat shrink tube is sleeved on a periphery of the liquid pipe.

In this way, a preload force can be provided for the liquid pipe based on a heat shrinking feature of the heat shrink tube. The preload force can make the terminal and the connector, and the connector and the liquid pipe closely fit, so that contact resistance and contact heat resistance between the terminal and the connector and between the connector and the liquid pipe are correspondingly reduced.

In a possible implementation, the heat dissipation structure includes a connecting piece and a second cooling medium. One end of the connecting piece is connected to the second end of the housing. The other end of the connecting piece is configured to connect to a cable. A cooling channel is disposed in the connecting piece. The cooling channel surrounds the second end of the housing. The second cooling medium flows in the cooling channel.

Specifically, the connecting piece may be made of a highly heat conductive and conductive material, such as metal or graphite. The connecting piece includes a first connection end and a second connection end. The first connection end is an end that is of the connecting piece and that is connected to the terminal body, and the second connection end is an end that is of the connecting piece and that is connected to the cable. In other words, the first connection end is connected to the second end of the terminal body, and the second connection end is connected to the cable.

A first accommodating hole is concavely disposed on an end face of the first connection end, and a tail end of the terminal body is accommodated in the first accommodating hole. A second accommodating hole is concavely disposed on an end face of the second connection end, and at least a part of the cable is accommodated in the second accommodating hole. Both the first accommodating hole and the second accommodating hole are of a blind hole structure.

In this implementation, the connecting piece and the terminal body may be connected in a detachable connection manner. The detachable connection manner can facilitate assembly of the terminal body and the connecting piece when the terminal body and the connecting piece need to be connected, and can be separated from each other when the terminal body and/or the connecting piece need to be repaired or replaced. In this way, disassembly and assembly are quick and convenient, and maintenance is convenient. This helps improve maintenance efficiency.

For example, a detachable connection manner between the connecting piece and the terminal body may be, but is not limited to, threaded connection, fastener connection, crimping, or a detachable clamp added at a joint between the connecting piece and the terminal body.

The cooling channel is disposed in the connecting piece, the cooling channel may surround the second end of the terminal body, and the second cooling medium flows in the cooling channel to dissipate heat for the terminal body. Alternatively, the cooling channel may surround the second end of the terminal body and one end that is connected between the cable and the connecting piece, and the second cooling medium flows in the cooling channel, to dissipate heat for the terminal body and the cable together. A channel form of the cooling channel may be a cavity channel, or may be a thread channel, provided that the second cooling medium can flow evenly in the connecting piece. This implementation imposes no strict limitation on the channel form of the cooling channel.

In this disposing manner, the connecting piece not only can implement connection between the terminal body and the cable, but also can provide a channel for the second cooling medium, to implement heat dissipation of the terminal body, thereby diversifying use performance of the connector.

For example, the second cooling medium may be any non-conductive liquid with good insulation. For example, the second cooling medium may include a combination of one or more of an inert fluoride liquid, a refrigerant R134a (1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

It may be understood that, when the charging terminal works, heat generated by the first end of the terminal body is transferred to the second end of the terminal body by using the heat conduction structure, and then is transferred to the connecting piece in contact with the second end of the terminal body. The cooling channel is disposed in the connecting piece. The second cooling medium enters the cooling channel through an inlet of the cooling channel, carries heat transferred by the connecting piece in a flow process in the cooling channel, flows out through an outlet of the cooling channel, and completes heat exchange with the connecting piece. This implements heat dissipation for the terminal body. In this disposing manner, the heat dissipation structure is simple in overall architecture and good in heat dissipation effect, and helps ensure temperature uniformity performance of the connecting piece, and meet application requirements in a plurality of scenarios. In addition, the second cooling medium in the connecting piece is independent of the first cooling medium in the terminal body. This can effectively avoid a leakage problem of the terminal body, and reliability is good.

It should be noted that the second cooling medium may independently dissipate heat for any charging terminal. For example, the second cooling medium may independently dissipate heat for a positive charging terminal or a negative charging terminal. In other words, the second cooling medium enters only a cooling channel of the positive charging terminal or a cooling channel of the negative charging terminal. Alternatively, the second cooling medium may also dissipate heat for a plurality of charging terminals together. For example, an insulation connection sleeve may be disposed between a cooling channel of a positive charging terminal and a cooling channel of a negative charging terminal. The insulation connection sleeve connects the cooling channel of the positive charging terminal and the cooling channel of the negative charging terminal. The second cooling medium may flow in the cooling channel of the positive charging terminal and the cooling channel of the negative charging terminal to dissipate heat for the positive charging terminal and the negative charging terminal together. A flow path of the second cooling medium is not strictly limited in this implementation.

In a possible implementation, the heat dissipation structure includes a connecting piece, a cable insulation sleeve, and a second cooling medium, one end of the connecting piece is connected to the second end of the housing, the other end of the connecting piece is configured to connect to a cable, a cooling channel is disposed in the connecting piece, the cable insulation sleeve is sleeved on a periphery of the other end of the connecting piece, there is a gap area between the cable insulation sleeve and the cable, the cooling channel extends from the connecting piece to the gap area, and the second cooling medium flows in the cooling channel and the gap area.

Specifically, the connecting piece may be made of a highly heat conductive and conductive material, such as metal or graphite. The connecting piece includes a first connection end and a second connection end. The first connection end is an end that is of the connecting piece and that is connected to the terminal body, and the second connection end is an end that is of the connecting piece and that is connected to the cable. In other words, the first connection end is connected to the second end of the terminal body, and the second connection end is connected to the cable.

A first accommodating hole is concavely disposed on an end face of the first connection end, and a tail end of the terminal body is accommodated in the first accommodating hole. A second accommodating hole is concavely disposed on an end face of the second connection end, and at least a part of the cable is accommodated in the second accommodating hole. Both the first accommodating hole and the second accommodating hole are of a blind hole structure.

In this implementation, the connecting piece and the terminal body may be connected in a detachable connection manner. The detachable connection manner can facilitate assembly of the terminal body and the connecting piece when the terminal body and the connecting piece need to be connected, and can be separated from each other when the terminal body and/or the connecting piece need to be repaired or replaced. In this way, disassembly and assembly are quick and convenient, and maintenance is convenient. This helps improve maintenance efficiency.

For example, a detachable connection manner between the connecting piece and the terminal body may be, but is not limited to, threaded connection, fastener connection, crimping, or a detachable clamp added at a joint between the connecting piece and the terminal body.

The cooling channel is disposed in the connecting piece, the cooling channel may surround the second end of the terminal body, and the second cooling medium flows in the cooling channel to dissipate heat for the terminal body. Alternatively, the cooling channel may surround the second end of the terminal body and one end that is connected between the cable and the connecting piece, and the second cooling medium flows in the cooling channel, to dissipate heat for the terminal body and the cable together. A channel form of the cooling channel may be a cavity channel, or may be a thread channel, provided that the second cooling medium can flow evenly in the connecting piece. This implementation imposes no strict limitation on the channel form of the cooling channel.

For example, the second cooling medium may be any non-conductive liquid with good insulation. For example, the second cooling medium may include a combination of one or more of an inert fluoride liquid, a refrigerant R134a (1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

In this implementation, the cable insulation sleeve is sleeved on a periphery of the second end of the connecting piece. There is a gap area between the cable insulation sleeve and the cable, and the gap area is conducted with the cooling channel. In other words, the cooling channel extends from the connecting piece to the gap area, and the second cooling medium flows in the cooling channel and the gap area.

In this disposing manner, the connecting piece not only can implement connection between the terminal body and the cable, but also can provide a channel for the second cooling medium, to implement heat dissipation of the terminal body, thereby diversifying use performance of the connector. The second cooling medium may also in direct contact with the cable, so that effect of heat dissipation on the cable can be further improved.

It may be understood that, when the charging terminal works, heat generated by the first end of the terminal body is transferred to the second end of the terminal body by using the heat conduction structure, and then is transferred to the connecting piece in contact with the second end of the terminal body. The cooling channel is disposed in the connecting piece. The second cooling medium enters the cooling channel through an inlet of the cooling channel, carries heat transferred by the connecting piece in a flow process in the cooling channel and enters the gap area, flows out through an outlet of the gap area after carrying heat of the cable, and completes heat exchange with the connecting piece and the cable. This implements heat dissipation for the terminal body and the cable together. In this disposing manner, the heat dissipation structure is simple in overall architecture and good in heat dissipation effect, and helps ensure temperature uniformity performance of the connecting piece, and meet application requirements in a plurality of scenarios. In addition, the second cooling medium in the connecting piece and the gap area is independent of the first cooling medium in the terminal body. This can effectively avoid a leakage problem of the terminal body, and reliability is good.

It should be noted that the second cooling medium may independently dissipate heat for any charging terminal and a cable connected to the charging terminal. For example, the second cooling medium may independently dissipate heat for a positive charging terminal and a cable connected to the positive charging terminal, or the second cooling medium may independently dissipate heat for a negative charging terminal and a cable connected to the negative charging terminal. In other words, the second cooling medium enters only a gap area between a cooling channel of the positive charging terminal and the cable connected to the positive charging terminal, or the second cooling medium enters only a gap area between a cooling channel of the negative charging terminal and the cable connected to the negative charging terminal.

Alternatively, the second cooling medium may also dissipate heat for a plurality of charging terminals together. For example, an insulation connection sleeve may be disposed between a cooling channel of a positive charging terminal and a cooling channel of a negative charging terminal. The insulation connection sleeve connects the cooling channel of the positive charging terminal and the cooling channel of the negative charging terminal. The second cooling medium may flow in the cooling channel of the positive charging terminal, a gap area of a cable connected to the positive charging terminal, the cooling channel of the negative charging terminal, and a gap area of a cable connected to the negative charging terminal, to dissipate heat for the positive charging terminal, the cable connected to the positive charging terminal, the negative charging terminal, and the cable connected to the negative charging terminal together. A flow path of the second cooling medium is not strictly limited in this implementation.

In a possible implementation, the heat dissipation structure further includes a plurality of spacers, and the plurality of spacers are arranged at spacings in the gap area, and are spirally wound around a periphery of the cable.

The spacer may be, but is not limited to, a support rope. In this way, the second cooling medium can flow evenly to various positions on the surface of the cable in the gap area, so that a surface temperature of the cable is uniform and consistent, and overall temperature uniformity of the cable is good.

In a possible implementation, the heat dissipation structure further includes a fastener, and the fastener is disposed around a periphery of the cable insulation sleeve, and is located at a joint between the cable insulation sleeve and the connecting piece.

Therefore, the fastener is installed at the joint between the connecting piece and the cable insulation sleeve. This can further prevent the cable insulation sleeve from falling off from the connecting piece and prevent the second cooling medium from being leaked, thereby fully utilizing cooling performance of the second cooling medium.

According to a second aspect, this application further provides a charging connector, where the charging connector includes a cable and the foregoing charging terminal, and the charging terminal is connected to the cable.

According to a third aspect, this application further provides a charging pile, where the charging pile includes a pile body and the foregoing charging connector, and a cable of the charging connector is electrically connected between the pile body and a charging terminal of the charging connector.

According to a fourth aspect, this application further provides a vehicle, where the vehicle includes a vehicle body and the foregoing charging terminal, and the charging terminal is connected to the vehicle body.

It may be understood that the charging terminal may be disposed on the charging connector as a male end, to connect to a charging socket on the vehicle as a female end. Alternatively, the charging terminal may be disposed on the vehicle as a male end, to connect to a charging socket on the charging connector as a female end. This is not strictly limited in the technical solution of this application.

### BRIEF DESCRIPTION OF DRAWINGS

FIG. 1 is a diagram of an application scenario of a charging pile according to an embodiment of this application;
FIG. 2 is a schematic diagram of a structure of a charging pile according to an embodiment of this application;
FIG. 3 is a schematic diagram of another structure of a charging pile according to an embodiment of this application;
FIG. 4 is a schematic diagram of a structure of a charging connector according to an embodiment of this application;
FIG. 5 is a schematic diagram of a structure of a charging terminal according to an implementation of an embodiment of this application;
FIG. 6 is a schematic cross-sectional diagram of the charging terminal shown in FIG. 5;
FIG. 7 is a schematic diagram of another structure of a charging terminal according to an implementation of an embodiment of this application;
FIG. 8 is a schematic cross-sectional diagram of the charging terminal shown in FIG. 7;
FIG. 9 is a schematic cross-sectional diagram of a charging terminal according to another implementation of an embodiment of this application;
FIG. 10 is another schematic cross-sectional diagram of a charging terminal according to another implementation of an embodiment of this application;
FIG. 11 is still another schematic cross-sectional diagram of a charging terminal according to another implementation of an embodiment of this application;
FIG. 12 is a schematic cross-sectional diagram of a charging terminal according to still another implementation of an embodiment of this application;
FIG. 13 is another schematic cross-sectional diagram of a charging terminal according to still another implementation of an embodiment of this application;
FIG. 14 is a schematic cross-sectional diagram of a terminal body of a charging terminal according to an embodiment of this application;
FIG. 15 is another schematic cross-sectional diagram of a terminal body of a charging terminal according to an embodiment of this application;
FIG. 16 is still another schematic cross-sectional diagram of a terminal body of a charging terminal according to an embodiment of this application; and
FIG. 17 is a schematic diagram of a structure of a spacer of a charging terminal according to an embodiment of this application.

### DESCRIPTION OF EMBODIMENTS

For ease of understanding, terms in embodiments of this application are first explained.

The term "and/or" describes only an association relationship for describing associated objects and represents that three relationships may exist. For example, A and/or B may represent the following three cases: Only A exists, both A and B exist, and only B exists.

The term "a plurality of" means "two or more".

The term "connection" should be understood in a broad sense. For example, if A is connected to B, A may be directly connected to B, or A may be indirectly connected to B through an intermediate medium.

The following clearly describes specific implementations of this application with reference to the accompanying drawings.

With rapid development of the new energy vehicle industry, an endurance mileage of an electric vehicle is continuously increased, and a capacity of a battery is also increasingly large. Therefore, increasing charging power to implement fast charging has been gradually put on the agenda. However, high-power charging causes heat consumption of a charging connector to increase, heat at a charging terminal cannot be dissipated, and consequently a terminal temperature exceeds a threshold. Therefore, heat dissipation of the charging terminal in the charging connector becomes a key problem that restricts an increase of charging power of the charging connector.

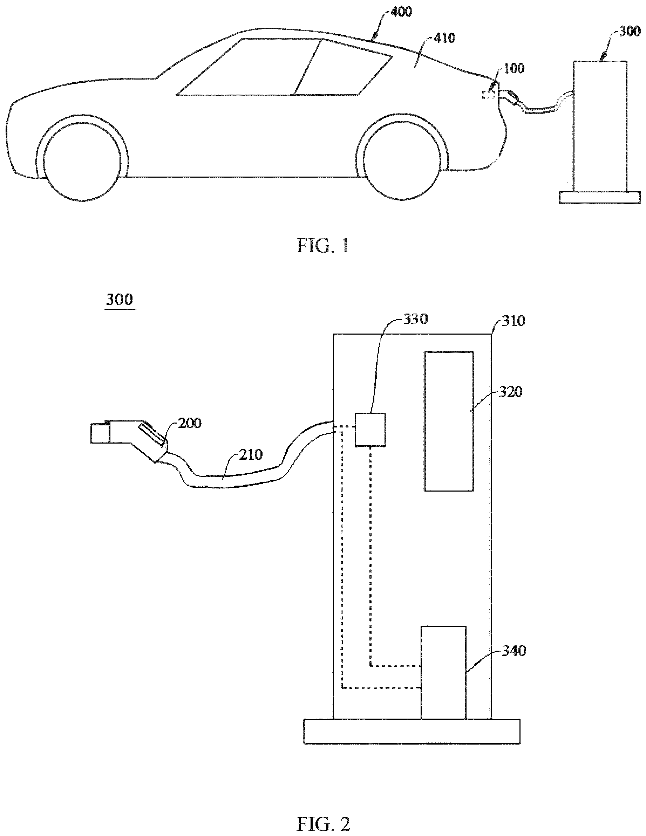

In view of this, with reference to FIG. 1 to FIG. 17, embodiments of this application provide a charging terminal 100, a charging connector 200 in which the charging terminal 100 is used, a charging pile 300 in which the charging connector 200 is used, and a vehicle 400 in which the charging terminal 100 is used, to implement good heat dissipation for the charging terminal 100 while ensuring that the charging terminal 100 has good working reliability, so that the charging connector 200 in which the charging terminal 100 is used has a good heat dissipation benefit.

Refer to FIG. 1. The vehicle 400 includes a vehicle body 410 and the charging terminal 100. The charging terminal 100 is connected to the vehicle body 410. The charging terminal 100 can be connected to a charging socket on the charging connector, to charge the vehicle 400 by using electric energy transferred by the charging connector.

The foregoing describes that the charging terminal 100 is disposed on the vehicle 400 as a male end, and is connected to the charging socket on the charging connector as a female end. With reference to FIG. 2 to FIG. 17, the following provides a detailed description by using an example in which the charging terminal 100 is disposed on the charging connector 200 as a male end, and is connected to the charging socket, on the vehicle, used as a female end.

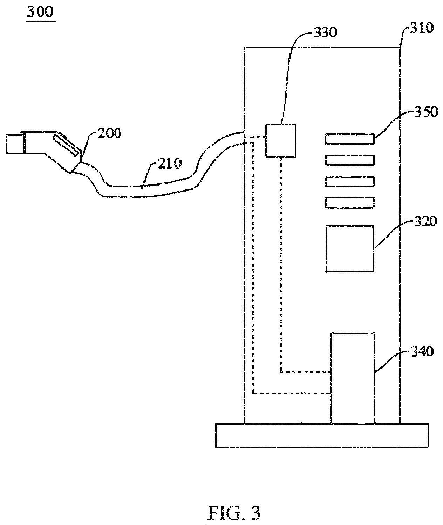

Refer to FIG. 2 and FIG. 3. The charging pile 300 includes a pile body 310 and the charging connector 200. The charging connector 200 is connected to the pile body 310, and can charge the vehicle by using electric energy supplied by the pile body 310.

It should be noted that FIG. 2 and FIG. 3 are merely intended to describe a connection relationship between the pile body 310 and the charging connector 200 as an example, and are not intended to specifically limit a connection position, a specific structure, and a quantity of devices. However, the schematic structure in this embodiment of this application does not constitute a specific limitation on the charging pile 300. In some other embodiments of this application, the charging pile 300 may include more or fewer components than those shown in the figure, combine some components, split some components, or have different component arrangements. The components shown in the figure may be implemented by hardware, software, or a combination of software and hardware.

In a specific application scenario, as shown in FIG. 2, the charging pile 300 is a charging terminal, and the charging terminal further includes a power distribution device 320, a water tank 330, and a cold source 340 connected to the water tank 330 and a cable 210, that are disposed inside the pile body 310. The power distribution device 320 can implement a power distribution function of the charging terminal. The cold source 340 may include a pump and a heat exchanger. The pump may be configured to provide power for a cooling medium, to drive the cooling medium to flow in the charging terminal to take away heat of the charging pile 300. The heat exchanger may use cold fluid in the heat exchanger to absorb heat of the high-temperature cooling medium through heat exchange, to implement heat exchange and cooling of the cooling medium, so that the cooling medium can be reused. In other words, the heat exchanger may be configured to perform heat exchange on the cooling medium that carries heat of the charging terminal to cool the cooling medium, so that the cooling medium can be reused.

In another specific application scenario, as shown in FIG. 3, the charging pile 300 is an integrated charging pile, and the integrated charging pile further includes a power module 350, a power distribution device 320, a water tank 330, and a cold source 340 connected to the water tank 330 and a cable 210, that are disposed inside the pile body 310. The power module 350 can implement a power conversion function of the integrated charging pile. The power distribution device 320 can implement a power distribution function of the charging terminal. The cold source 340 may include a pump and a heat exchanger. The pump may be configured to provide power for a cooling medium, to drive the cooling medium to flow in the charging terminal to take away heat of the charging pile 300. The heat exchanger may use cold fluid in the heat exchanger to absorb heat of the high-temperature cooling medium through heat exchange, to implement heat exchange and cooling of the cooling medium, so that the cooling medium can be reused. In other words, the heat exchanger may be configured to perform heat exchange on the cooling medium that carries heat of the charging terminal to cool the cooling medium, so that the cooling medium can be reused.

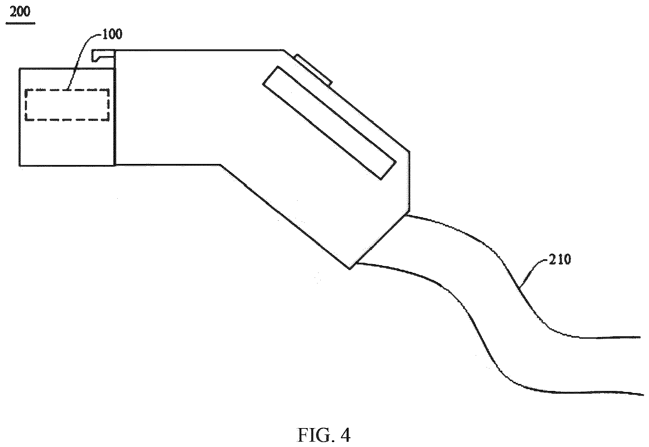

Refer to FIG. 4. The charging connector 200 includes a cable 210 and a charging terminal 100. The cable 210 is electrically connected between the pile body 310 and the charging terminal 100, to transfer, to the charging terminal 100, electric energy supplied by the pile body 310, and connect the charging terminal 100 to a charging socket on a vehicle to charge the vehicle.

It should be noted that FIG. 4 is merely intended to describe a connection relationship between the cable 210 and the charging terminal 100 as an example, and does not specifically limit a connection position, a specific structure, and a quantity of devices. However, the schematic structure in this embodiment of this application does not constitute a specific limitation on the charging connector 200. In some other embodiments of this application, the charging connector 200 may include more or fewer components than those shown in the figure, combine some components, split some components, or have different component arrangements. The components shown in the figure may be implemented by hardware, software, or a combination of software and hardware.

For example, there may be two charging terminals 100: a positive charging terminal and a negative charging terminal. The positive charging terminal and the negative charging terminal have a same structure and opposite polarities.

It should be noted that a key design of this embodiment of this application is not the cable 210, and a specific structure and a connection position of the cable 210 are not strictly limited. The charging terminal 100 is not only applicable to the foregoing charging connector 200, but also applicable to any device that has a requirement for the charging terminal 100, for example, a wired charger or a wireless charger. This is not strictly limited in this embodiment of this application.

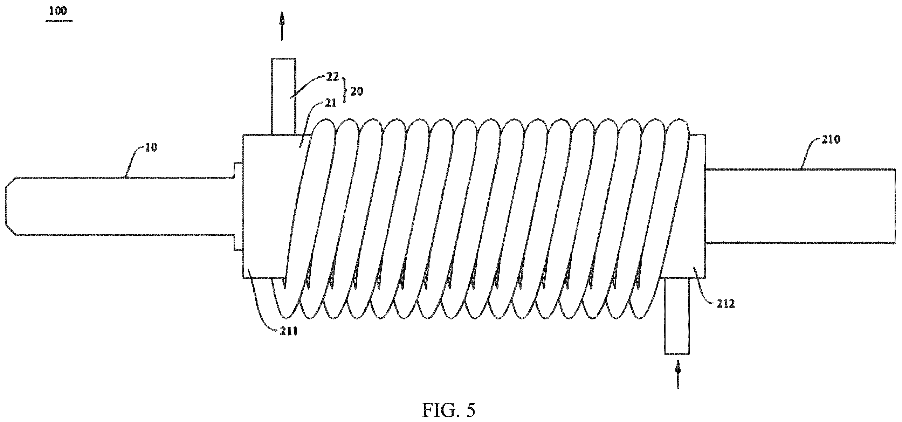

The following describes a detailed structure of the charging terminal 100 with reference to FIG. 5 to FIG. 17. Arrows in FIG. 4 to FIG. 13 indicate a flow direction of a cooling medium.

Refer to FIG. 5 to FIG. 13. The charging terminal 100 includes a terminal body 10, a heat dissipation structure 20, and an insulation cap 30. The terminal body 10 has good electrical performance and heat conduction performance, and can quickly conduct heat generated during working to the heat dissipation structure 20. The insulation cap 30 is connected to one end that is of the terminal body 10 and that is connected to a charging socket, to provide insulation protection for the terminal body 10. The heat dissipation structure 20 is connected to the other end that is of the terminal body 10 and that is away from the charging socket, to implement good heat dissipation of the terminal body 10.

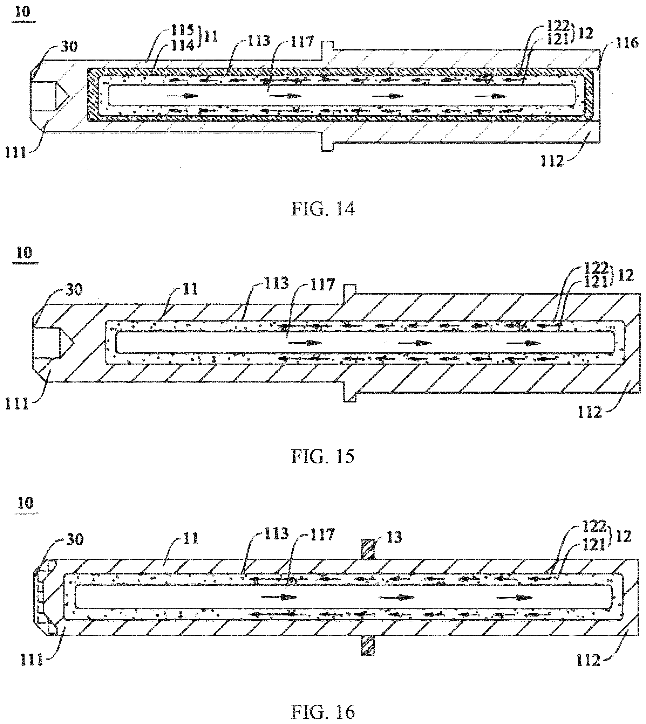

Refer to FIG. 14, FIG. 15, and FIG. 16. Specifically, the terminal body 10 includes a housing 11 and a heat conduction structure 12. The housing 11 includes a first end 111 and a second end 112. The first end 111 is an end that is connected to a charging socket, and may be understood as a head end of the housing 11. The second end 112 is the other end away from the charging socket, and may be understood as a tail end of the housing 11. The insulation cap 30 is connected to the first end 111 of the housing 11, and the heat dissipation structure 20 is connected to the second end 112 of the housing 11. The housing 11 has a sealing cavity 113, and the sealing cavity 113 extends from the first end 111 to the second end 112. The heat conduction structure 12 is connected to an inner wall of the sealing cavity 113, and extends from the first end 111 to the second end 112.

It may be understood that, when the charging terminal 100 works, a current passes through the charging terminal 100. Because of existence of contact resistance and resistance of the terminal itself, heat consumption of one end, namely, the first end 111, that is of the terminal and that is in contact with the charging socket is large, and heat of the end needs to be conducted and dissipated in time, to avoid a temperature of the charging terminal 100 exceeding a threshold. A length of the terminal body 10 is large, to be specific, a distance between the first end 111 of the charging terminal 100 and the second end 112 of the charging terminal 100 is long. Therefore, when the charging terminal 100 works, heat generated during charging is conducted from the first end 111 to the second end 112 with large heat resistance, resulting in poor heat dissipation performance of the charging terminal 100.

In this way, the sealing cavity 113 extending from the first end 111 to the second end 112 is disposed inside the terminal body 10, and the heat conduction structure 12 is accommodated in the sealing cavity 113 and extends from the first end 111 to the second end 112. On the one hand, because of good sealing performance of the sealing cavity 113, heat conduction performance of the heat conduction structure 12 accommodated in the sealing cavity is not affected by an external environment factor. On the other hand, an extension path of the heat conduction structure 12 and an extension path of the housing 11 can overlap and be distributed at various positions on an extension path of the housing 11.

In this disposing manner, when the charging terminal 100 works, the heat conduction structure 12 can quickly transfer heat generated by the first end 111 of the housing 11, namely, the end that is in contact with the charging socket, to the second end 112 of the housing 11 in a timely manner, and dissipate the heat by using the heat dissipation structure 20 disposed at the second end 112. In other words, the heat conduction structure 12 extends from the first end 111 to the second end 112, so that the temperature of the housing 11 is more consistent. This not only can fully ensure temperature uniformity of the housing 11, but also significantly improve heat transfer efficiency between the first end 111 and the second end 112, thereby improving overall heat dissipation performance of the charging terminal 100, and improving overall working reliability of the charging terminal 100.

In a possible implementation, as shown in FIG. 14, the housing 11 includes an inner housing 114 and an outer housing 115 sleeved on a periphery of the inner housing 114, and the inner housing 114 forms a sealing cavity 113. Two ends of the outer housing 115 are the first end 111 and the second end 112 of the housing 11 described above. Specifically, an insulation cap interface may be disposed at one end (namely, the first end 111) that is of the outer housing 115 and that is in contact with the charging socket, to accommodate the insulation cap 30. The other end (namely, the second end 112) that is of the outer housing 115 and that is away from the charging socket is provided with a mounting groove 116 extending from one end to the other end, so that the inner housing 114 is accommodated in the mounting groove.

In this disposing manner, the inner housing 114 and the heat conduction structure 12 may jointly form a heat conduction member that can independently perform heat conduction, and the mounting groove 116 is disposed in the outer housing 115. On one hand, the heat conduction member formed by the inner housing 114 and the heat conduction structure 12 can be conveniently and quickly inserted into the mounting groove, so that the heat conduction member can be closely combined with the outer housing 115, to achieve good heat conduction performance of the charging terminal 100. On the other hand, the heat conduction member may be replaced in time after the working life of the heat conduction member expires. This helps ensure working reliability of the charging terminal 100.

For example, a manner of combining the inner housing 114 and the outer housing 115 may be but is not limited to an interference fitting manner, a crimping manner, a welding manner, or the like.

It should be noted that, in this implementation, an example in which a groove structure that can be accommodated by the inner housing 114 is formed inside the outer housing 115 is used for description. However, in another implementation, a hole structure (for example, a blind hole) that can be accommodated by the inner housing 114 may also be formed inside the outer housing 115. This implementation is not strictly limited thereto.

In another possible implementation, as shown in FIG. 15, the heat conduction structure 12 is connected to the housing 11 to form an integrated structure, that is, the terminal body 10 is of an integrated structure. In this disposing manner, on the one hand, because there is no other mechanical part between the heat conduction structure 12 and the housing 11, heat resistance of contact between the heat conduction structure and the housing can be reduced. This helps improve overall heat conduction performance of the charging terminal 100. On the other hand, the integrated structure can make processing and manufacturing of the terminal body 10 simple, which helps improve overall structural strength of the terminal body 10 and improve production efficiency of preparing the terminal body 10.

For example, the heat conduction structure 12 and the housing 11 may be of the integrated structure formed by using assembly such as welding or bonding, or the heat conduction structure 12 and the housing 11 may be of an integrated structure formed by using an integrated molding process. In addition, an insulation cap interface may be disposed at the first end 111 of the housing 11 to accommodate an insulation cap 30.

In still another possible implementation, as shown in FIG. 16, the terminal body 10 is a heat pipe. To be specific, the housing 11 and the heat conduction structure 12 may jointly form the heat pipe, and the heat pipe may directly form the terminal body 10, so that the terminal body 10 not only has good heat conduction performance, but also can achieve good electrical connection performance.

For example, in consideration of sealing of the heat pipe, the first end 111 of the housing 11 may not be provided with an insulation cap interface, but the insulation cap 30 is disposed on an end face of the first end 111 of the housing 11. A connection manner in which the insulation cap 30 is disposed at the first end 111 of the housing 11 may be but is not limited to bonding, crimping, welding, or the like. However, due to a structure rule of the heat pipe, to facilitate disposing of the heat dissipation structure 20, a ribbed plate 13 may be additionally disposed on a periphery of the housing 11, to connect the heat dissipation structure 20. In addition, an outer surface of the terminal body 10 may be plated with silver, to reduce contact resistance between the terminal body and the charging socket, thereby helping ensure working performance of the charging terminal 100.

It should be noted that, in this implementation, the wall thickness of the housing 11 may be properly thickened while ensuring working performance. This is conducive to improving overall structural strength of the terminal body 10.

Based on the descriptions of the foregoing three implementations, it should be understood that a structure of the terminal body 10 has diversified deformation possibilities, and may be flexibly selected based on an actual application scenario of the charging terminal 100, and reliability is good.

Refer to FIG. 14, FIG. 15, and FIG. 16. The heat conduction structure 12 covers an inner wall of the sealing cavity 113, and can transfer heat of the first end 111 to the second end 112. Specifically, the heat conduction structure 12 includes a capillary structure 121 and a first cooling medium 122. The capillary structure 121 covers the inner wall of the sealing cavity 113. The first cooling medium 122 is filled in the capillary structure 121. The first cooling medium 122 is configured to transfer heat of the first end 111 to the second end 112 through gas-liquid conversion.

The capillary structure 121 may be implemented by using a structure such as sintering, a liquid absorption core, a braided mesh (mesh), or a fine fiber (fine fiber). The first cooling medium 122 may be any conductive or non-conductive liquid having a two-phase conversion function (that is, capable of vaporizing when heated and liquefying when cooled). For example, the first cooling medium 122 may include a combination of one or more of water, an inert fluoride liquid, a refrigerant R134a (1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

It may be understood that, because the first end 111 of the housing 11 is in direct contact with the charging socket, the first end of the housing has a high temperature during working, and is an evaporation end of the charging terminal 100. The second end 112 of the housing 11 has a low temperature because the second end 112 is disposed away from the charging socket and close to the heat dissipation structure 20, and is a condensation end of the charging terminal 100.

The first cooling medium 122 is filled in the capillary structure 121, and the capillary structure 121 covers the inner wall of the sealing cavity 113. Therefore, the first cooling medium 122 can have a large contact area with the housing 11. When the charging terminal 100 works and heats up, the first cooling medium 122 may carry heat of the housing 11 in time, and vaporize after being heated at the evaporation end (namely, the first end 111) due to the two-phase conversion performance of the first cooling medium. Vapor formed after the vaporization is cooled and condensed at the condensation end (namely, the second end 112), becomes a liquid through cooling, and quickly flows back under a capillary force of the capillary structure 121. Therefore, heat transfer between the first end 111 and the second end 112 can be implemented in a cycle through continuous gas-liquid conversion of "evaporation-condensation-...-evaporation" of the first cooling medium 122. Heat transfer efficiency is high and contact heat conduction performance is good.

In this embodiment of this application, an area enclosed by the capillary structure 121 forms a steam channel 117 for the first cooling medium 122. That is, all areas outside the coverage area of the capillary structure 121 in the sealing cavity 113 may be understood as the steam channel 117 for the first cooling medium 122, and the steam channel 117 can extend from the first end 111 to the second end 112.

It may be understood that, the steam channel 117 is reserved in the sealing cavity 113, to provide a proper space for steam to flow. There is a distance difference between the first end 111 and the second end 112, and the distance difference is conducive to implementing two-phase conversion of the first cooling medium 122, so that the first cooling medium 122 evaporates and flows to the second end 112 when being heated at the first end 111, and condenses and flows back to the first end 111 under a capillary force of a capillary structure 121 after being cooled at the second end 112. The gas-liquid conversion of the cooling medium is implemented in a cycle.

In this embodiment of this application, the heat dissipation structure 20 is connected to the second end 112, and can effectively dissipate heat transferred by the heat conduction structure 12 from the first end 111 to the second end 112. Refer to FIG. 5 to FIG. 13. The following describes a detailed structure and an actual application of the heat dissipation structure 20 in three specific implementations.

In a possible implementation, as shown in FIG. 5, FIG. 6, FIG. 7, and FIG. 8, the heat dissipation structure 20 may include a connecting piece 21, a liquid pipe 22, and a second cooling medium. In FIG. 5 to FIG. 9, an arrow represents a flow direction of the second cooling medium.

Specifically, the connecting piece 21 may be made of a highly heat conductive and conductive material, such as metal or graphite. The connecting piece 21 includes a first connection end 211 and a second connection end 212. The first connection end 211 is an end that is of the connecting piece 21 and that is connected to the terminal body 10, and the second connection end 212 is an end that is of the connecting piece 21 and that is connected to the cable 210. In other words, the first connection end 211 is connected to the second end 112 of the terminal body 10, and the second connection end 212 is connected to the cable 210.

A first accommodating hole 213 is concavely disposed on an end face of the first connection end 211, and a tail end of the terminal body 10 is accommodated in the first accommodating hole 213. A second accommodating hole 214 is concavely disposed on an end face of the second connection end 212, and at least a part of the cable 210 is accommodated in the second accommodating hole 214. Both the first accommodating hole 213 and the second accommodating hole 214 are of a blind hole structure.

In this implementation, the connecting piece 21 and the terminal body 10 may be connected in a detachable connection manner. The detachable connection manner can facilitate assembly of the terminal body 10 and the connecting piece 21 when the terminal body and the connecting piece need to be connected, and can be separated from each other when the terminal body 10 and/or the connecting piece 21 need to be repaired or replaced. In this way, disassembly and assembly are quick and convenient, and maintenance is convenient. This helps improve maintenance efficiency.

For example, a detachable connection manner between the connecting piece 21 and the terminal body 10 may be, but is not limited to, threaded connection, fastener connection, crimping, or a detachable clamp added at a joint between the connecting piece 21 and the terminal body 10.

As shown in FIG. 5 to FIG. 8, the liquid pipe 22 is disposed around the periphery of the connecting piece 21, and the second cooling medium flows in the liquid pipe 22 to take away heat. For example, the liquid pipe 22 may be made of an insulation material. The second cooling medium may include a combination of one or more of water, an inert fluoride liquid, a refrigerant R134a(1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

It may be understood that, when the charging terminal 100 works, heat generated by the first end 111 of the terminal body 10 is transferred to the second end 112 of the terminal body 10 by using the heat conduction structure 12, and then is transferred to the connecting piece 21 in contact with the second end 112 of the terminal body 10. The liquid pipe 22 is spirally wound around the connecting piece 21, and the second cooling medium enters the liquid pipe 22 through an inlet of the liquid pipe 22, carries the heat transferred by the connecting piece 21 in a flow process in the liquid pipe 22, flows out through an outlet of the liquid pipe 22, and completes heat exchange with the connecting piece 21. This implements heat dissipation for the terminal body 10. In this disposing manner, the heat dissipation structure 20 is simple in overall architecture and low in requirement for insulation of the cooling medium, and helps meet application requirements in a plurality of scenarios.

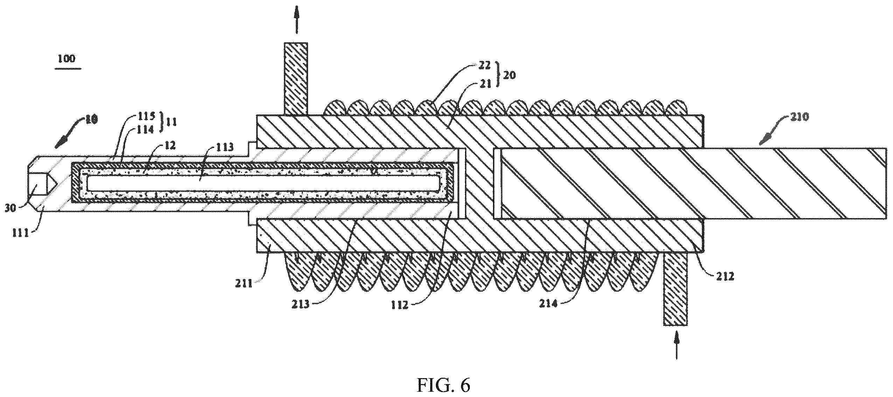

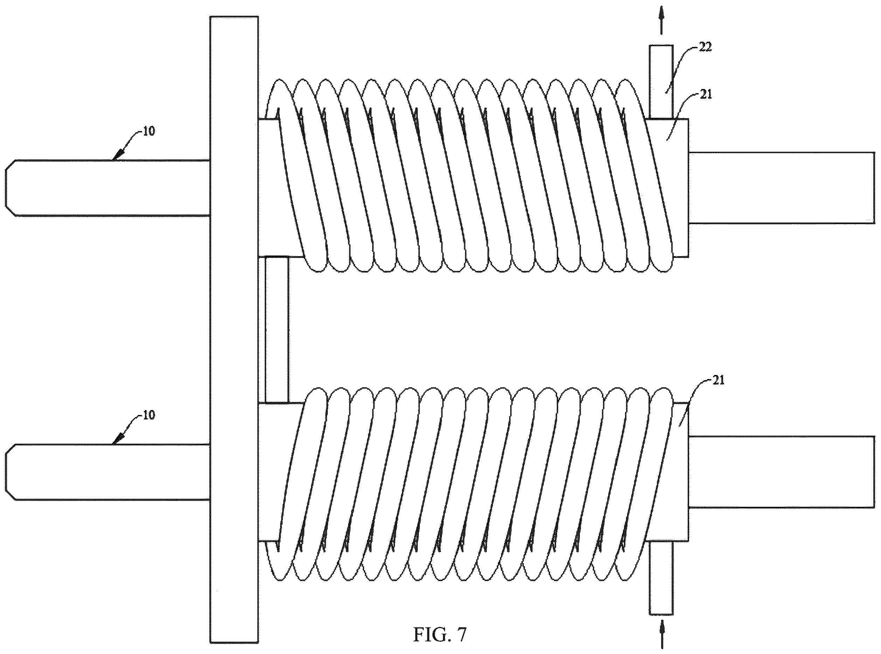

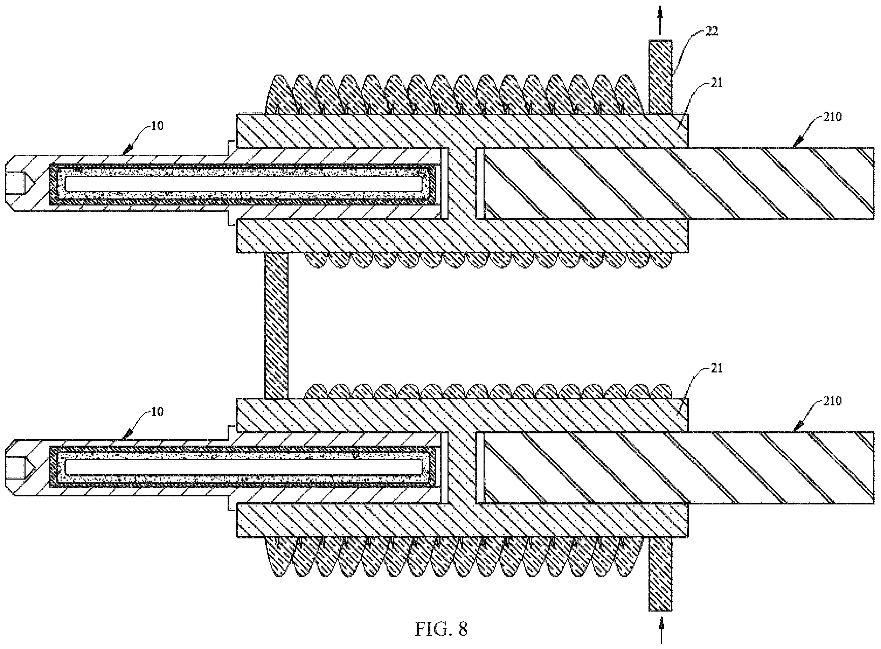

It should be noted that, as shown in FIG. 5 and FIG. 6, the liquid pipe 22 may independently dissipate heat for any charging terminal 100. For example, the liquid pipe 22 may independently dissipate heat for a positive charging terminal or a negative charging terminal. In other words, the liquid pipe 22 is independently wound around the positive charging terminal or the negative charging terminal. Alternatively, as shown in FIG. 7 and FIG. 8, the liquid pipe 22 may also dissipate heat for a plurality of charging terminals 100 together. For example, the liquid pipe 22 may dissipate heat for both the positive charging terminal and the negative charging terminal. In other words, the liquid pipe 22 is wound around the positive charging terminal and the negative charging terminal. A heat dissipation form of the liquid pipe 22 is not strictly limited in this implementation.

For example, the heat dissipation structure 20 may further include a heat shrink tube, and the heat shrink tube is sleeved on a periphery of the liquid pipe 22. In this way, a preload force can be provided for the liquid pipe 22 based on a heat shrinking feature of the heat shrink tube. The preload force can make the terminal and the connector, and the connector and the liquid pipe 22 closely fit, so that contact resistance and contact heat resistance between the terminal and the connector and between the connector and the liquid pipe 22 are correspondingly reduced.

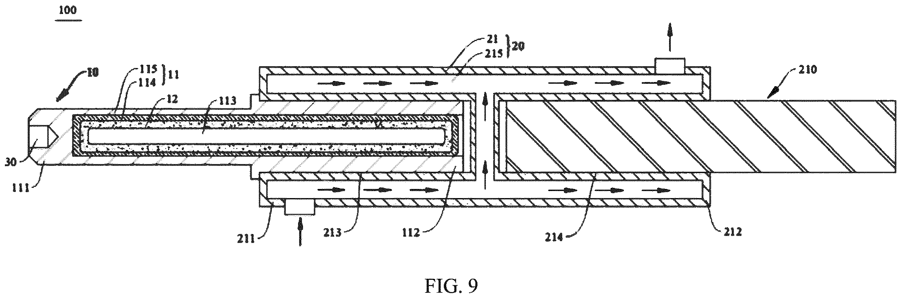

In another possible implementation, as shown in FIG. 9, FIG. 10, and FIG. 11, the heat dissipation structure 20 may include a connecting piece 21 and a second cooling medium, where in FIG. 9, FIG. 10, and FIG. 11, an arrow represents a flow direction of the second cooling medium.

Specifically, the connecting piece 21 may be made of a highly heat conductive and conductive material, such as metal or graphite. The connecting piece 21 includes a first connection end 211 and a second connection end 212. The first connection end 211 is an end that is of the connecting piece 21 and that is connected to the terminal body 10, and the second connection end 212 is an end that is of the connecting piece 21 and that is connected to the cable 210. In other words, the first connection end 211 is connected to the second end 112 of the terminal body 10, and the second connection end 212 is connected to the cable 210.

A first accommodating hole 213 is concavely disposed on an end face of the first connection end 211, and a tail end of the terminal body 10 is accommodated in the first accommodating hole 213. A second accommodating hole 214 is concavely disposed on an end face of the second connection end 212, and at least a part of the cable 210 is accommodated in the second accommodating hole 214. Both the first accommodating hole 213 and the second accommodating hole 214 are of a blind hole structure.

In this implementation, the connecting piece 21 and the terminal body 10 may be connected in a detachable connection manner. The detachable connection manner can facilitate assembly of the terminal body 10 and the connecting piece 21 when the terminal body and the connecting piece need to be connected, and can be separated from each other when the terminal body 10 and/or the connecting piece 21 need to be repaired or replaced. In this way, disassembly and assembly are quick and convenient, and maintenance is convenient. This helps improve maintenance efficiency.

For example, a detachable connection manner between the connecting piece 21 and the terminal body 10 may be, but is not limited to, threaded connection, fastener connection, crimping, or a detachable clamp added at a joint between the connecting piece 21 and the terminal body 10.

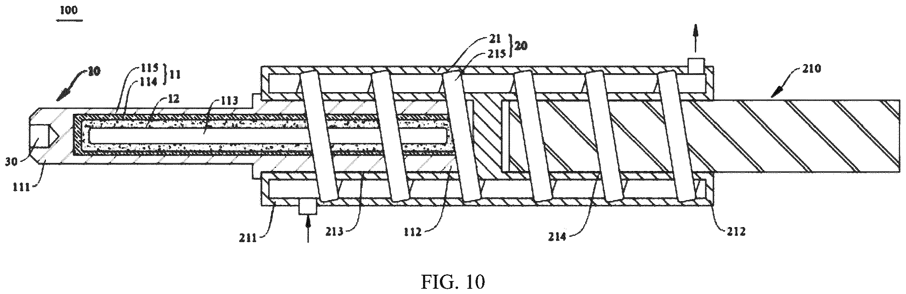

As shown in FIG. 9 and FIG. 10, a cooling channel 215 is disposed in the connecting piece 21, the cooling channel 215 may surround the second end 112 of the terminal body 10, and the second cooling medium flows in the cooling channel 215 to dissipate heat for the terminal body 10. Alternatively, the cooling channel 215 may surround the second end 112 of the terminal body 10 and one end that is connected between the cable 210 and the connecting piece 21, and the second cooling medium flows in the cooling channel 215, to dissipate heat for the terminal body 10 and the cable 210 together. A channel form of the cooling channel 215 may be a cavity channel shown in FIG. 9, or may be a threaded channel shown in FIG. 10, provided that the second cooling medium can flow evenly in the connecting piece. This implementation imposes no strict limitation on the channel form of the cooling channel 215.

In this disposing manner, the connecting piece 21 not only can implement connection between the terminal body 10 and the cable 210, but also can provide a channel for the second cooling medium, to implement heat dissipation of the terminal body 10, thereby diversifying use performance of the connector.

For example, the second cooling medium may be any non-conductive liquid with good insulation. For example, the second cooling medium may include a combination of one or more of an inert fluoride liquid, a refrigerant R134a (1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

It may be understood that, when the charging terminal 100 works, heat generated by the first end 111 of the terminal body 10 is transferred to the second end 112 of the terminal body 10 by using the heat conduction structure 12, and then is transferred to the connecting piece 21 in contact with the second end 112 of the terminal body 10. The cooling channel 215 is disposed in the connecting piece 21. The second cooling medium enters the cooling channel 215 through an inlet of the cooling channel 215, carries heat transferred by the connecting piece 21 in a flow process in the cooling channel 215, flows out through an outlet of the cooling channel 215, and completes heat exchange with the connecting piece 21. This implements heat dissipation for the terminal body 10. In this disposing manner, the heat dissipation structure 20 is simple in overall architecture and good in heat dissipation effect, and helps ensure temperature uniformity performance of the connecting piece 21, and meet application requirements in a plurality of scenarios. In addition, the second cooling medium in the connecting piece 21 is independent of the first cooling medium 122 in the terminal body 10. This can effectively avoid a leakage problem of the terminal body 10, and reliability is good.

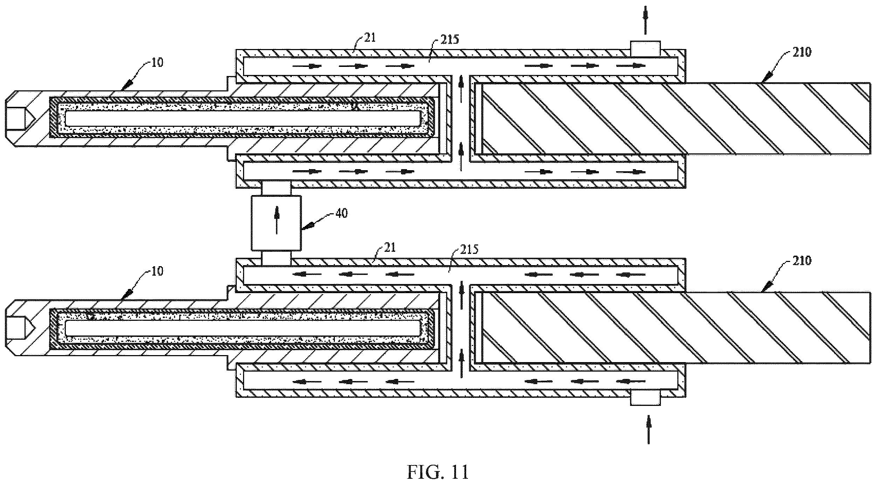

It should be noted that, as shown in FIG. 9 and FIG. 10, the second cooling medium may independently dissipate heat for any charging terminal 100. For example, the second cooling medium may independently dissipate heat for a positive charging terminal or a negative charging terminal. In other words, the second cooling medium enters only a cooling channel 215 of the positive charging terminal or a cooling channel 215 of the negative charging terminal. Alternatively, as shown in FIG. 11, the second cooling medium may dissipate heat for a plurality of charging terminals 100 together. For example, an insulation connection sleeve 40 may be disposed between a cooling channel 215 of a positive charging terminal and a cooling channel 215 of a negative charging terminal. The insulation connection sleeve 40 connects the cooling channel 215 of the positive charging terminal and the cooling channel 215 of the negative charging terminal. The second cooling medium may flow in the cooling channel 215 of the positive charging terminal and the cooling channel 215 of the negative charging terminal to dissipate heat for the positive charging terminal and the negative charging terminal together. A flow path of the second cooling medium is not strictly limited in this implementation.

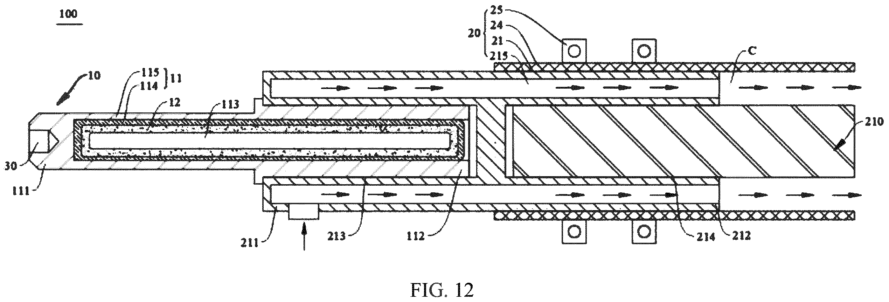

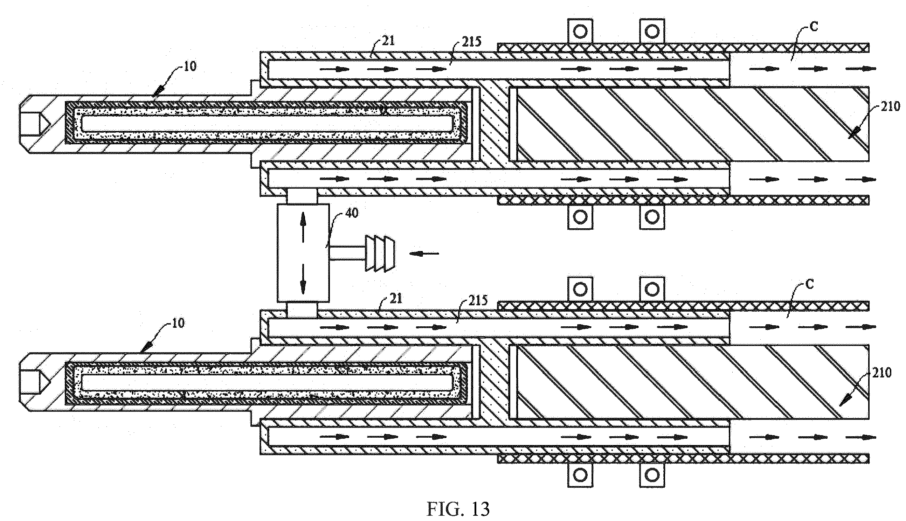

In another possible implementation, as shown in FIG. 12 and FIG. 13, the heat dissipation structure 20 includes a connecting piece 21, a cable insulation sleeve 24, and a second cooling medium. In FIG. 12 and FIG. 13, an arrow represents a flow direction of the second cooling medium.

Specifically, the connecting piece 21 may be made of a highly heat conductive and conductive material, such as metal or graphite. The connecting piece 21 includes a first connection end 211 and a second connection end 212. The first connection end 211 is an end that is of the connecting piece 21 and that is connected to the terminal body 10, and the second connection end 212 is an end that is of the connecting piece 21 and that is connected to the cable 210. In other words, the first connection end 211 is connected to the second end 112 of the terminal body 10, and the second connection end 212 is connected to the cable 210.

A first accommodating hole 213 is concavely disposed on an end face of the first connection end 211, and a tail end of the terminal body 10 is accommodated in the first accommodating hole 213. A second accommodating hole 214 is concavely disposed on an end face of the second connection end 212, and at least a part of the cable 210 is accommodated in the second accommodating hole 214. Both the first accommodating hole 213 and the second accommodating hole 214 are of a blind hole structure.

In this implementation, the connecting piece 21 and the terminal body 10 may be connected in a detachable connection manner. The detachable connection manner can facilitate assembly of the terminal body 10 and the connecting piece 21 when the terminal body and the connecting piece need to be connected, and can be separated from each other when the terminal body 10 and/or the connecting piece 21 need to be repaired or replaced. In this way, disassembly and assembly are quick and convenient, and maintenance is convenient. This helps improve maintenance efficiency.

For example, a detachable connection manner between the connecting piece 21 and the terminal body 10 may be, but is not limited to, threaded connection, fastener connection, crimping, or a detachable clamp added at a joint between the connecting piece 21 and the terminal body 10.

As shown in FIG. 12 and FIG. 13, a cooling channel 215 is disposed in the connecting piece 21, the cooling channel 215 may surround the second end 112 of the terminal body 10, and the second cooling medium flows in the cooling channel 215 to dissipate heat for the terminal body 10. Alternatively, the cooling channel 215 may surround the second end 112 of the terminal body 10 and one end that is connected between the cable 210 and the connecting piece 21, and the second cooling medium flows in the cooling channel 215, to dissipate heat for the terminal body 10 and the cable 210 together. A channel form of the cooling channel 215 may be a cavity channel, or may be a thread channel, provided that the second cooling medium can flow evenly in the connecting piece. This implementation imposes no strict limitation on the channel form of the cooling channel 215.

For example, the second cooling medium may be any non-conductive liquid with good insulation. For example, the second cooling medium may include a combination of one or more of an inert fluoride liquid, a refrigerant R134a (1,1,1,2-tetrafluoroethane), a refrigerant R245fa (1,1,3,3-pentafluoropropane), a refrigerant R1234ze (1,1,1,3-tetrafluoropropene), and a refrigerant R1233zd (1-chloro-3,3,3-trifluoropropane).

In this implementation, the cable insulation sleeve 24 is sleeved on a periphery of the second end 112 of the connecting piece 21. There is a gap area C between the cable insulation sleeve 24 and the cable 210, and the gap area C is conducted with the cooling channel 215. In other words, the cooling channel 215 extends from the connecting piece 21 to the gap area C, and the second cooling medium flows in the cooling channel 215 and the gap area C.

In this disposing manner, the connecting piece 21 not only can implement connection between the terminal body 10 and the cable 210, but also can provide a channel for the second cooling medium, to implement heat dissipation of the terminal body 10, thereby diversifying use performance of the connector. The second cooling medium may also in direct contact with the cable 210, so that effect of heat dissipation on the cable 210 can be further improved.

As shown in FIG. 12, the heat dissipation structure 20 may further include a fastener 25. The fastener 25 is disposed around a periphery of the cable insulation sleeve 24, and is located at a joint between the cable insulation sleeve 24 and the connecting piece 21. For example, the fastener 25 may be a clamp. Therefore, the fastener 25 is installed at the joint between the connecting piece 21 and the cable insulation sleeve 24. This can further prevent the cable insulation sleeve 24 from falling off from the connecting piece 21 and prevent the second cooling medium from being leaked, thereby fully utilizing cooling performance of the second cooling medium.

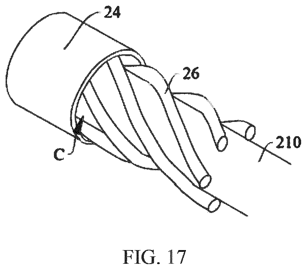

For example, as shown in FIG. 17, the heat dissipation structure 20 may further include a plurality of spacers 26. The plurality of spacers 26 are arranged at spacings in the gap area C, and are spirally wound around a periphery of the cable 210. The spacer 26 may be, but is not limited to, a support rope. In this way, the second cooling medium can flow evenly to various positions on the surface of the cable 210 in the gap area C, so that a surface temperature of the cable 210 is uniform and consistent, and overall temperature uniformity of the cable 210 is good.

It may be understood that, when the charging terminal 100 works, heat generated by the first end 111 of the terminal body 10 is transferred to the second end 112 of the terminal body 10 by using the heat conduction structure 12, and then is transferred to the connecting piece 21 in contact with the second end 112 of the terminal body 10. The cooling channel 215 is disposed in the connecting piece 21. The second cooling medium enters the cooling channel 215 through an inlet of the cooling channel 215, carries heat transferred by the connecting piece 21 in a flow process in the cooling channel 215 and enters the gap area C, flows out through an outlet of the gap area C after carrying heat of the cable 210, and completes heat exchange with the connecting piece 21 and the cable 210. This implements heat dissipation for the terminal body 10 and the cable 210 together. In this disposing manner, the heat dissipation structure 20 is simple in overall architecture and good in heat dissipation effect, and helps ensure temperature uniformity performance of the connecting piece 21, and meet application requirements in a plurality of scenarios. In addition, the second cooling medium in the connecting piece 21 and the gap area C is independent of the first cooling medium 122 in the terminal body 10. This can effectively avoid a leakage problem of the terminal body 10, and reliability is good.

It should be noted that, as shown in FIG. 12, the second cooling medium may independently dissipate heat for any charging terminal 100 and a cable 210 connected to the charging terminal 100. For example, the second cooling medium may independently dissipate heat for the positive charging terminal and a cable 210 connected to the positive charging terminal, or the second cooling medium may independently dissipate heat for the negative charging terminal and a cable 210 connected to the negative charging terminal. In other words, the second cooling medium enters only a gap area C between a cooling channel 215 of the positive charging terminal and the cable 210 connected to the positive charging terminal, or the second cooling medium enters only a gap area C between a cooling channel 215 of the negative charging terminal and the cable 210 connected to the negative charging terminal.

Alternatively, as shown in FIG. 13, the second cooling medium may also dissipate heat for a plurality of charging terminals 100. For example, an insulation connection sleeve 40 may be disposed between a cooling channel 215 of the positive charging terminal and a cooling channel 215 of the negative charging terminal. The insulation connection sleeve 40 connects a cooling channel 215 of the positive charging terminal and a cooling channel 215 of the negative charging terminal. The second cooling medium may flow in the cooling channel 215 of the positive charging terminal, a gap area C of a cable 210 connected to the positive charging terminal, the cooling channel 215 of the negative charging terminal, and a gap area C of the cable 210 connected to the negative charging terminal, to dissipate heat for the positive charging terminal, the cable 210 connected to the positive charging terminal, the negative charging terminal, and the cable 210 connected to the negative charging terminal. A flow path of the second cooling medium is not strictly limited in this implementation.

The foregoing describes embodiments of this application in detail. The principle and implementation of this application are described herein through specific examples. The description about embodiments of this application is merely provided to help understand the method and core ideas of this application. In addition, persons of ordinary skill in the art can make variations and modifications to this application in terms of the specific implementations and application scopes according to the ideas of this application. Therefore, the content of specification shall not be construed as a limit to this application.

## Claims

1. A charging terminal, wherein the charging terminal comprises:
a terminal body, wherein the terminal body comprises a housing and a heat conduction structure, the housing comprises a first end and a second end, the housing has a sealing cavity, the sealing cavity extends from the first end to the second end, and the heat conduction structure is connected to an inner wall of the sealing cavity and extends from the first end to the second end; and
a heat dissipation structure, wherein the heat dissipation structure is connected to the second end of the housing.

2. The charging terminal according to claim 1, wherein the heat conduction structure comprises a capillary structure and a first cooling medium, the capillary structure covers the inner wall of the sealing cavity, the first cooling medium is filled in the capillary structure, an area enclosed by the capillary structure forms a steam channel for the first cooling medium, and the first cooling medium is configured to transfer heat at the first end to the second end through gas-liquid conversion.

3. The charging terminal according to claim 1 or 2, wherein the heat conduction structure is connected to the housing to form an integrated structure.

4. The charging terminal according to claim 1 or 2, wherein the housing comprises an outer housing and an inner housing, the outer housing has a mounting groove, the mounting groove is configured to accommodate the inner housing, and the inner housing has the sealing cavity.

5. The charging terminal according to claim 1, wherein the terminal body is a heat pipe.

6. The charging terminal according to any one of claims 1 to 5, wherein the heat dissipation structure comprises a connecting piece, a liquid pipe, and a second cooling medium, one end of the connecting piece is connected to the second end of the housing, the other end of the connecting piece is configured to connect to a cable, the liquid pipe is wound around a periphery of the connecting piece, and the second cooling medium flows in the liquid pipe.

7. The charging terminal according to claim 6, wherein the heat dissipation structure further comprises a heat shrink tube, and the heat shrink tube is sleeved on a periphery of the liquid pipe.

8. The charging terminal according to any one of claims 1 to 5, wherein the heat dissipation structure comprises a connecting piece and a second cooling medium, one end of the connecting piece is connected to the second end of the housing, the other end of the connecting piece is configured to connect to a cable, a cooling channel is disposed in the connecting piece, the cooling channel surrounds the second end of the housing, and the second cooling medium flows in the cooling channel.

9. The charging terminal according to any one of claims 1 to 5, wherein the heat dissipation structure comprises a connecting piece, a cable insulation sleeve, and a second cooling medium, one end of the connecting piece is connected to the second end of the housing, the other end of the connecting piece is configured to connect to a cable, a cooling channel is disposed in the connecting piece, the cable insulation sleeve is sleeved on a periphery of the other end of the connecting piece, there is a gap area between the cable insulation sleeve and the cable, the cooling channel extends from the connecting piece to the gap area, and the second cooling medium flows in the cooling channel and the gap area.

10. The charging terminal according to claim 9, wherein the heat dissipation structure further comprises a plurality of spacers, and the plurality of spacers are arranged at spacings in the gap area, and are spirally wound around a periphery of the cable.

11. The charging terminal according to claim 9 or 10, wherein the heat dissipation structure further comprises a fastener, and the fastener is disposed around a periphery of the cable insulation sleeve, and is located at a joint between the cable insulation sleeve and the connecting piece.

12. A charging connector, wherein the charging connector comprises a cable and the charging terminal according to any one of claims 1 to 11, and the charging terminal is connected to the cable.

13. A charging pile, wherein the charging pile comprises a pile body and the charging connector according to claim 12, and a cable of the charging connector is electrically connected between the pile body and a charging terminal of the charging connector.

14. A vehicle, wherein the vehicle comprises a vehicle body and the charging terminal according to any one of claims 1 to 11, and the charging terminal is connected to the vehicle body.
